# EUROPEAN PATENT APPLICATION

(11) **EP 4 387 096 A1**
(43) Date of publication of application: **19.06.2024**
(21) Application number: 22855817.7
(22) Date of filing: 01.08.2022
(51) Int. Cl.: H03F 3/60, H01P 5/02, H03F 3/189, H03H 7/01

(54) **HIGH FREQUENCY AMPLIFIER**

(30) Priority: 10.08.2021 JP 2021130711
(71) Applicant: Kyosan Electric Mfg. Co., Ltd., Tsurumi-ku, Yokohama-shi Kanagawa 230-0031 (JP)
(72) Inventor: KUNITAMA Hiroshi, Yokohama-shi, Kanagawa 230-0031 (JP); YOSHIDA Takuya, Yokohama-shi, Kanagawa 230-0031 (JP)
(74) Representative: Hoffmann Eitle
(86) International application number: PCT/JP2022/029545
(87) International publication number: WO 2023/017754

(57) **Abstract**

This high frequency amplifier includes: an amplifier that amplifies a high frequency signal; and an impedance adjustment unit that adjusts impedance relative to a high frequency wave as seen from the amplifier to a load side. The impedance adjustment unit includes a distributed constant circuit and a lumped constant circuit. The distributed constant circuit includes a transmission line that resonates with harmonics, and the lumped constant circuit includes a resonance circuit that resonates with a fundamental wave and harmonics other than the harmonics of the distributed constant circuit. One end of the transmission line of the distributed constant circuit is an open end, and is constituted from an open stub provided with a line length that resonates with various harmonics. The high frequency amplifier carries out filtering by adjusting the impedance of the fundamental wave and the harmonics without being provided with a fundamental wave 1/4 wavelength transmission line.

## Description

### [TECHNICAL FIELD]

The present invention relates to a high frequency amplifier for a class-F amplifier and an inverse class-F amplifier.

### [BACKGROUND ART]

In an amplifier, instantaneous power consumption in a transistor is indicated with a product of an instantaneous current and an instantaneous voltage, and a time average value of integral in one period of a radio frequency (RF) of the instantaneous power consumption corresponds to time average of the power consumption in the transistor.

A class-A amplifier has a current and a voltage, which are sine waves whose phases are opposite to each other, in a drain terminal of a transistor, and an overlap between the waveforms of the current and the voltage is large in the operation of the class-A amplifier. Consequently, the efficiency of the amplifier is low. In the operation of a class-B amplifier, a drain current is biased to have a half-wave rectified waveform, and a drain voltage is a sine wave voltage. In the operation of the class-B amplifier having the drain voltage as a sine wave voltage, an overlap between the waveforms of the current and the voltage is small but not eliminated. In order to increase the efficiency of the amplifier, it is required that an instantaneous voltage and an instantaneous current do not exist at the same time in the relationship of the drain voltage and the drain current.

For increasing the efficiency of the amplifier, class-D amplifiers and class-E amplifiers are known for achieving high efficiency based on a voltage/current relationship in a time domain, and class-F amplifiers and inverse class-F amplifiers are known for achieving the high efficiency based on a voltage/current relationship in a frequency domain.

The frequency component of the half-wave rectified current flowing through the transistor is a fundamental wave and even harmonics of a cosine function. A sequence of trigonometric functions is a sequency of orthogonal functions, so that a value of integral in one period of instantaneous power is zero even if a current and a voltage at different frequencies are exist at the same time, and power consumption does not occur. The voltage at the drain terminal of the transistor is set to the fundamental wave and odd harmonics, which has a negative phase relationship with the current, so as to generate power with a power factor of 100 % for the fundamental wave, and thereby the power consumption is zero for all harmonics.

In a current-voltage relationship in which the power consumption is zero for all harmonics, a class-F load circuit of the class-F amplifier causes a load impedance viewed from an output terminal of the transistor to the load side to be short-circuited for the even harmonics and to be open-circuited for the odd harmonics. As a consequence, all current harmonics are even harmonics and all voltage harmonics are odd harmonics.

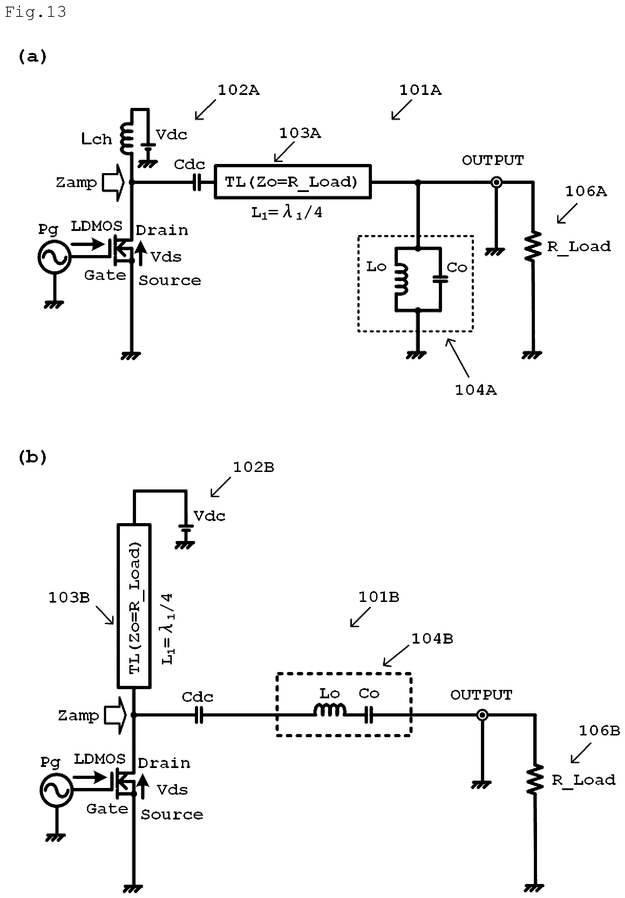

Figures 13(a) and 13(b) show configuration examples of the class-F amplifier, the class-F amplifier consisting of a direct current feed circuit and a load circuit. The load circuit is designed such that a load impedance is zero for even harmonics and infinite for odd harmonics.

In FIG. 13(a), a class-F amplifier 101A includes a direct current feed circuit 102A, a transmission line 103A that is connected in series to an output line between a drain end of an LDMOS constituting the direct current feed circuit 102A and a load 106A, and a parallel-resonant circuit 104A that is connected in parallel to the output line. A transmission line length L₁ of the transmission line 103A is 1/4 of a wavelength λ₁ of a fundamental wave. The parallel-resonant circuit 104A adjusts the impedance to be an open state for fundamental frequencies while adjusting the impedance to be a short-circuit state for high frequencies. The transmission line 103A is in an open state for the odd harmonics by impedance conversion of the transmission line and remains in a short-circuit state for the even harmonics because the impedance conversion of the transmission line does not work (see Patent Literature 1).

In FIG. 13(b), a class-F amplifier 101B includes a direct current feed circuit 102B, a transmission line 103B that is connected to a direct current feed line between a DC power source of the direct current feed circuit 102B and a drain end of an LDMOS, and a series-resonant circuit 104B that is connected in series between the drain end and a load 106B. The series-resonant circuit 104B in FIG. 13(b) is a resonance circuit in which an inductor Lo is connected with a capacitor Co in series.

A transmission line length L₁ of the transmission line 103B is 1/4 of a wavelength λ₁ of a fundamental wave, and one end of the transmission line is short-circuited for high frequencies by capacitance. The transmission line length corresponds to 1/2 wavelength for a second harmonic and 3/4 wavelength for a third harmonic, so that a load condition is satisfied in that the transmission line is short-circuited for the second harmonic while being open-circuited for the third harmonics (see Patent Literature 2).

In contrast to the class-F load circuit, an inverse class-F load circuit adjusts the load impedance to be an open state for the even harmonics while adjusting it to be a short-circuit state for the odd harmonics. Consequently, all current harmonics are odd harmonics and all voltage harmonics are even harmonics (see Patent Literature 3).

### [CITATION LIST]

### [PATENT LITERATURE]

[Patent Literature 1] Japanese Patent Laid-Open Publication No. H09-266421
[Patent Literature 2] Japanese Patent Laid-Open Publication No. H11-234062
[Patent Literature 3] International Publication No. 2013/157298

### [SUMMARY OF THE INVENTION]

### [PROBLEMS TO BE SOLVED BY THE INVENTION]

The class-F amplifier is required to have load impedance conditions for short-circuiting the even harmonics and opening the odd harmonics in order to satisfy the requirement of the current-voltage relationship in which the power consumption is zero for all harmonics. A conventional class-F amplifier includes a transmission line whose length L₁ is 1/4 of a wavelength λ₁ of a fundamental wave (i.e., λ₁/4) in order to satisfy the load impedance conditions.

The inverse class-F amplifier is required to have load impedance conditions for short-circuiting the odd harmonics and opening the even harmonics. A conventional inverse class-F amplifier also conducts the impedance conversion by means of a quarter-wavelength transmission line for a fundamental wave to thereby satisfy the load impedance conditions of the inverse class-F amplifier.

The conventional class-F amplifier and inverse class-F amplifier have a problem of the increase in the circuit size of the amplifier. The increase in the circuit size is caused by the following factors.

(a) Increase in size due to line length of quarter-wavelength transmission line for fundamental wave
   The class-F amplifier and the inverse class-F amplifier have the problem of the increase in the circuit size of the amplifier caused because the transmission line length L₁ of the quarter-wavelength transmission line for the fundamental wave is long when a frequency f₁ (=c (light speed)/λ₁) of a transistor output is low and the wavelength λ₁ of the fundamental wave is long.
(b) Increase in size due to conductor width of quarter-wavelength transmission line for fundamental wave
   In a configuration of providing the quarter-wavelength transmission line for the fundamental wave to a DC power feeding line, the quarter-wavelength transmission line for the fundamental wave needs a conductor width according to feeding power, and the conductor width of the quarter-wavelength transmission line for the fundamental wave increases as the feeding power increases. The increase in the conductor width causes the increase in the circuit size of the amplifier.
(c) Increase in size due to line length of stub for harmonics
   A resonance circuit consists of a branched transmission line (stub) has a problem of the increase in the circuit size of the amplifier caused because the length of the branched transmission line (stub) is long when the waveform λₙ (where n is an order of harmonic) of the harmonic is long.

Thus, the high-frequency amplifiers of the class-F amplifier and the inverse class-F amplifier have the problem of the increase in the circuit size of the amplifiers. An object of the present invention is to solve the above existing problem and reduce the circuit size.

### [MEANS FOR SOLVING THE PROBLEM]

A high-frequency amplifier of the present invention includes an amplifier that amplifies a high-frequency signal, and an impedance adjustment unit that adjusts an impedance for a high frequency as seen from the amplifier side to a load side. The impedance adjustment unit is configured not to need a quarter-wavelength transmission line for a fundamental wave so as to adjust an impedance for filtering the fundamental wave and harmonics. The configuration which does not need the quarter-wavelength transmission line for the fundamental wave can eliminate the size increase due to the line length and the conductor width of the quarter-wavelength transmission line for the fundamental wave.

The impedance adjustment unit of the high-frequency amplifier of the invention is configured to include a distributed constant circuit and a lumped constant circuit. The distributed constant circuit includes a transmission line having a line length that resonates with harmonics, and the lumped constant circuit includes a resonance circuit that resonates with harmonics other than the harmonics of the distributed constant circuit and the fundamental wave. The transmission line of the distributed constant circuit has its one end to be an open end, and is composed of an open stub having a line length resonating each harmonic.

In addition to that, the impedance adjustment unit uses the lumped constant circuit instead of the distributed constant circuit using the stub that needs a long line length at the harmonics, so as to adjust the impedance to eliminate the increase in the circuit size due to the line length of the stub for the harmonics.

The high-frequency amplifier of the invention can employ the class-F amplifier or inverse class-F amplifier for improving efficiency through the voltage-current relationship in a frequency domain.

### (High-Frequency Amplifier for Class-F Amplifier)

In the current-voltage relationship in which the power consumption is zero at all harmonics, the impedance condition of the class-F amplifier is that a load impedance as seen from an output terminal of a transistor to a load side is a short-circuit state at an even harmonic and an open state at an odd harmonic. Due to this impedance condition of the class-F amplifier, current harmonics are only even harmonics and voltage harmonics are only odd harmonics.

In the impedance adjustment unit included in the high-frequency amplifier for the class-F amplifier, the transmission line of the distributed constant circuit is an open stub for conducting the impedance adjustment to obtain zero impedance for an even harmonic, and the resonance circuit of the lumped constant circuit is an inductive load for conducting the impedance adjustment to obtain high impedances for the fundamental wave and the odd harmonics. With this configuration, the impedance adjustment unit conducts the impedance adjustment for the class-F operation. The high-frequency amplifier for the class-F amplifier conducts the impedance adjustment with the open stub on the even harmonics in the distributed constant circuit and conducts the impedance adjustment with the inductive load on the odd harmonics in the lumped constant circuit.

The inductive load for conducting the impedance adjustment for the fundamental wave is composed of the resonance circuit of the lumped constant circuit so that the transmission line having the quarter-wavelength of that of the fundamental wave is not necessary, and thereby the increase in the circuit size due to the line length and the conductor width of the transmission line having the quarter-wavelength of that of the fundamental wave can be prevented.

The resonance circuit forming the inductive load is composed of an inductor connected between a node on an output side of the distributed constant circuit and a node on an input side of the load, and a capacitor connected between the node on the input side of the load and a grounding end.

In a case where the resonance circuit is formed by a branched transmission line (stub), the length of the branched transmission line (stub) is long when a wavelength λₙ of the harmonic is long (where n is an order of the harmonic), causing the increase in the circuit size. Since the class-F amplifier of the invention has the resonance circuit formed by the lumped constant circuit, the problem of the size increase can be avoided.

A transmission line having the second longest line length after the transmission line of the fundamental wave is the branched transmission line (stub) that conducts the impedance adjustment to obtain zero impedance for a second harmonic. The lumped constant circuit includes the resonance circuit for conducting the impedance adjustment to obtain zero impedance for the second harmonic, instead of using the open stub for the second harmonic included in the distributed constant circuit. Consequently, it is not necessary to use the transmission line (stub) having the long line length.

### (High-Frequency Amplifier for Inverse Class-F Amplifier)

In the current-voltage relationship in which the power consumption is zero at all harmonics, the impedance condition of the inverse class-F amplifier is that a load impedance as seen from an output terminal of a transistor to a load side is a short-circuit state for an odd harmonic and an open state for an even harmonic. Due to this impedance condition of the class-F amplifier, all current harmonics are odd harmonics and all voltage harmonics are even harmonics.

In the impedance adjustment unit included in a high-frequency amplifier for the inverse class-F amplifier, a transmission line of a distributed constant circuit is an open stub for conducting the impedance adjustment to obtain zero impedance for an odd harmonic, and a resonance circuit of a lumped constant circuit is composed of an inductor and a capacitor. The lumped constant circuit is a capacitive load, and conducts the impedance adjustment on the fundamental wave to be an inductive load while conducting the impedance adjustment to obtain a high impedance for the even harmonic. With this configuration, the impedance adjustment unit conducts the impedance adjustment of the inverse class-F operation. The high-frequency amplifier for the inverse class-F amplifier conducts the impedance adjustment with the capacitive load of the lumped constant circuit on the even harmonics and conducts the impedance adjustment with the open stub of the distributed constant circuit on the odd harmonics.

The resonance circuit for the lumped constant circuit adjusts the fundamental wave to be the inductive load to make the capacitive load for conducting the impedance adjustment on the even harmonics to be capacitive. Consequently, it is not necessary to use the transmission line having the quarter-wavelength of that of the fundamental wave, thereby preventing the increase in the circuit size due to the line length and the conductor width of the transmission line having the quarter-wavelength of that of the fundamental wave.

In the lumped constant circuit, the resonance circuit forming the capacitive load is composed of a capacitor connected between a node on an output side of the distributed constant circuit and an inductor connected in series with respect to the load.

In a case where the resonance circuit is formed by a branched transmission line (stub), the length of the transmission line (stub) is long when a wavelength λₙ of the harmonic (where n is an order of the harmonic) is long, causing the increase in the circuit size. In the inverse class-F amplifier, the resonance circuit as the capacitive load uses only the fundamental wave as the inductive load to conduct the impedance adjustment to obtain a high impedance for the even harmonics. Consequently, it is not necessary to use the transmission line (stub) having the long line length, thereby avoiding the problem of the increase in the circuit size.

In the inverse class-F amplifier, a transmission line having the second longest line length after the transmission line for the fundamental wave is the branched transmission line (stub) that conducts the impedance adjustment to obtain zero impedance for a third harmonic. The lumped constant circuit includes the resonance circuit for conducting the impedance adjustment to obtain zero impedance for the third harmonic, instead of using the open stub for the third harmonic included in the distributed constant circuit.

The high-frequency amplifier of the invention can be applied for a push-pull configuration to obtain a high-power output with small distortion.

### (Push-Pull Circuit of Class-F Amplifier)

In the high-frequency amplifier of the invention, the push-pull configuration of the class-F amplifier has a push-pull circuit formed by two amplifiers that amplify high-frequency signals whose phases are opposite to each other, and the two amplifiers are connected to a load through an output transformer.

The inductive load of the impedance adjustment unit can be configured in various forms.

### (a) First form of inductive load

A first form of the inductive load is configured by a leakage inductance of the output transformer and a capacitor connected in parallel on a secondary side of the output transformer.

### (b) Second form of inductive load

A second form of the inductive load is configured by an inductor connected in series on a primary side of the output transformer and the capacitor connected in parallel on the primary or secondary side of the output transformer.

### (c) Third form of inductive load

A third form of the inductive load is configured by the inductor connected in series on the secondary side of the output transformer and the capacitor connected in parallel on the secondary side of the output transformer.

### (Push-Pull Circuit of Inverse Class-F Amplifier)

In the high-frequency amplifier of the invention, the push-pull configuration of the class-F amplifier has a push-pull circuit that is formed by two amplifiers for amplifying high-frequency signals whose phases are opposite to each other, and the two amplifiers are connected to the load via the output transformer. One form of the capacitive load of the impedance adjustment unit is configured with the resonance circuit consisting of the inductor and the capacitor which are connected on the primary side or secondary side of the output transformer.

### (Multi-layer structure)

The high-frequency amplifier of the invention can have a form in which the transmission line is arranged on a dielectric layer of a multi-layer substrate.

### (a) First form of multi-layer substrate

In a first form of the multi-layer substrate, the distributed constant circuit is composed of a GND layer and a multi-layer substrate of a substrate layer of a dielectric body, and an open stub is arranged in the substrate layer for conducting the impedance adjustment to obtain zero impedance for the second harmonic.

### (b) Second form of multi-layer substrate

In a second form of the multi-layer substrate, the distributed constant circuit is composed of the GND layer and the multi-layer substrate of the substrate layer of the dielectric body, and the open stub is arranged in the substrate layer for conducting the impedance adjustment to obtain zero impedance for the third harmonic.

The open stub is arranged in the dielectric body so that the line length of the transmission line is shortened, thereby downsizing the circuit size.

### [EFFECTS OF THE INVENTION]

As described above, in accordance with the present invention, the circuit size of the high-frequency amplifiers for the class-F amplifier and the inverse class-F amplifier can be reduced.

### [BRIEF DESCRIPTION OF THE DRAWINGS]

Figure 1 illustrates a schematic configuration of a high-frequency amplifier of the present invention;
Figure 2 illustrates a high-frequency amplifier for a class-F amplifier of the present invention;
Figure 3 is a circuit example showing an inductive load included in the high-frequency amplifier for the class-F amplifier;
Figure 4 illustrates a configuration example of the high-frequency amplifier for the class-F amplifier by a push-pull configuration;
Figure 5 illustrates a configuration example of the high-frequency amplifier for the class-F amplifier by the push-pull configuration
Figure 6 illustrates a configuration example of the high-frequency amplifier for the class-F amplifier by the push-pull configuration;
Figure 7 illustrates a configuration example of the high-frequency amplifier for the class-F amplifier by the push-pull configuration;
Figuration 8 illustrates a high-frequency amplifier of an inverse class-F amplifier of the present invention;
Figure 9 illustrates a circuit example of a capacitive load included in the high-frequency amplifier for the inverse class-F amplifier;
Figure 10 illustrates a configuration example of a high-frequency amplifier for an inverse class-F amplifier by a push-pull configuration;
Figure 11 illustrates a configuration example of the high-frequency amplifier for the inverse class-F amplifier by the push-pull configuration;
Figure 12 illustrates a multi-layer structure of the high-frequency amplifier of the present invention; and
Figure 13 shows a configuration example of a conventional class-F amplifier.

### [BEST MODE FOR CARRYING OUT THE INVENTION]

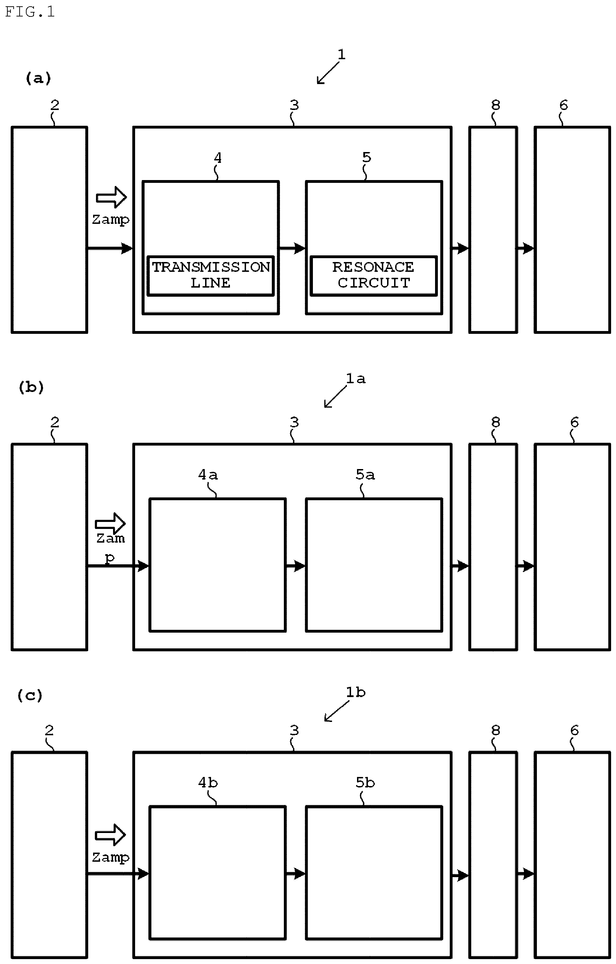

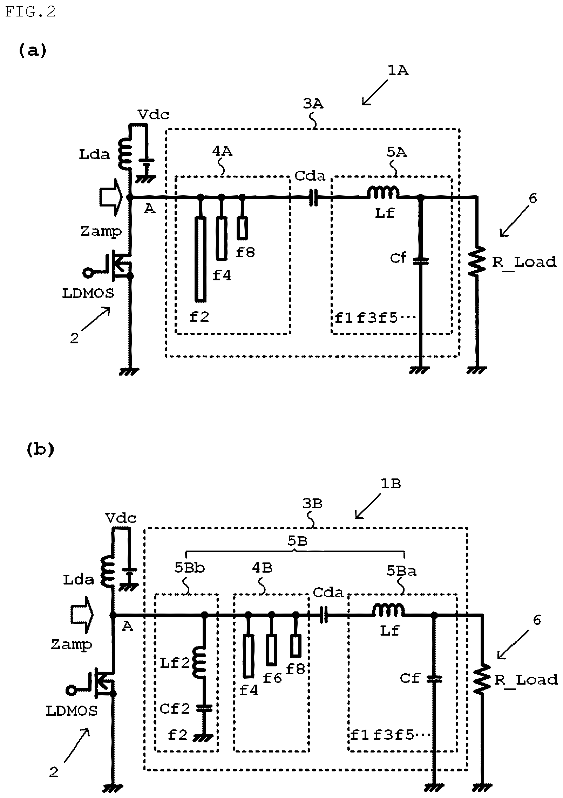

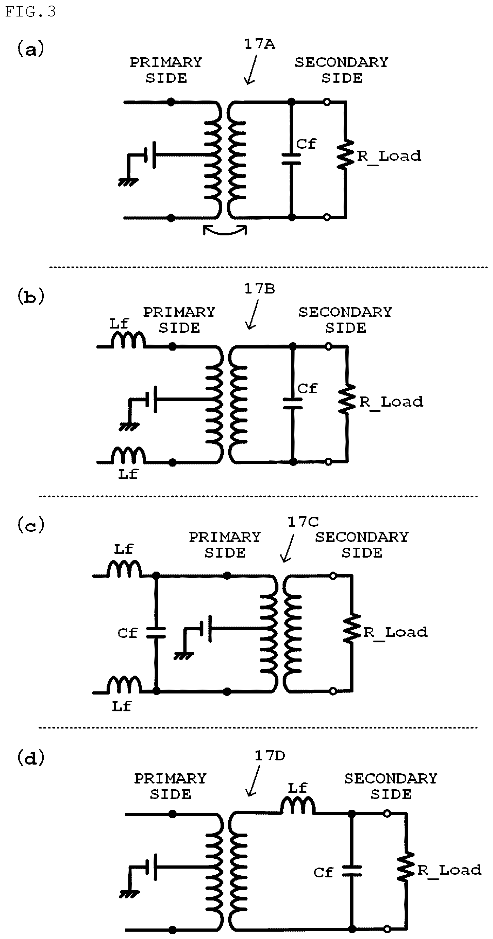

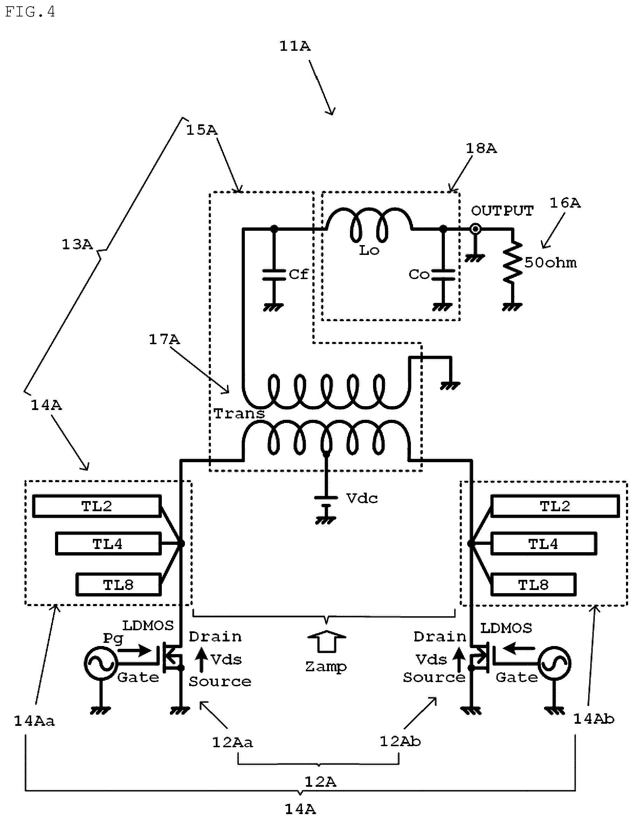

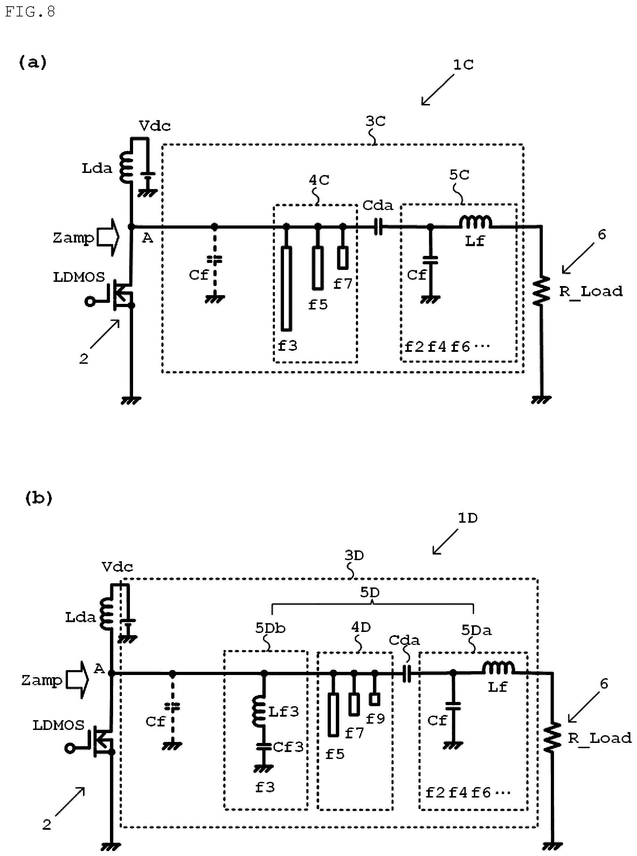

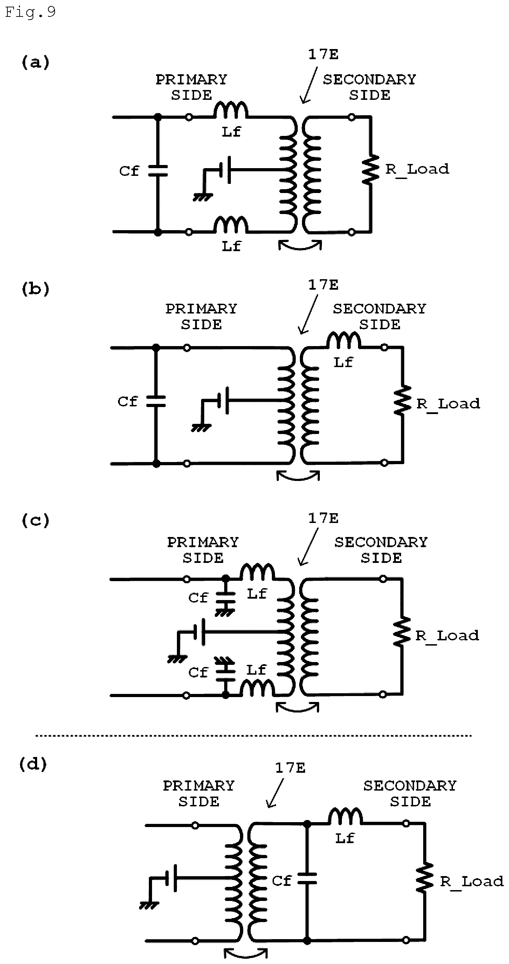

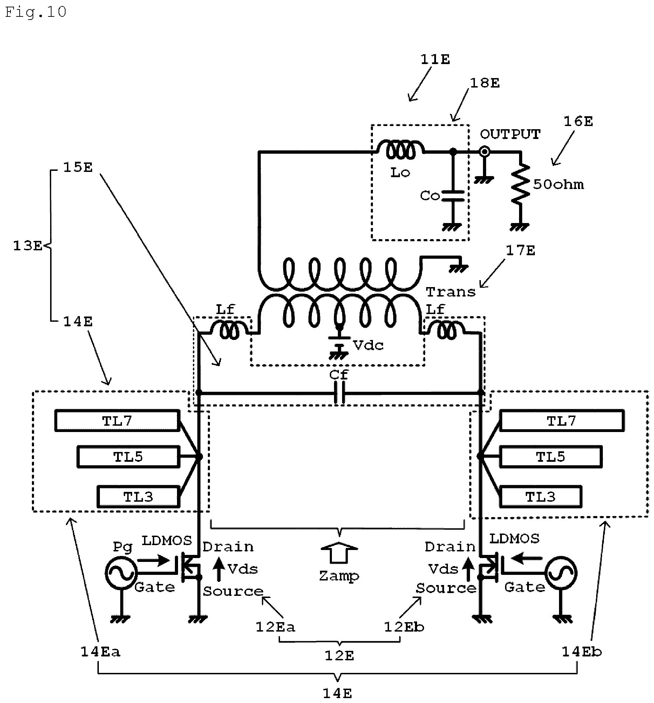

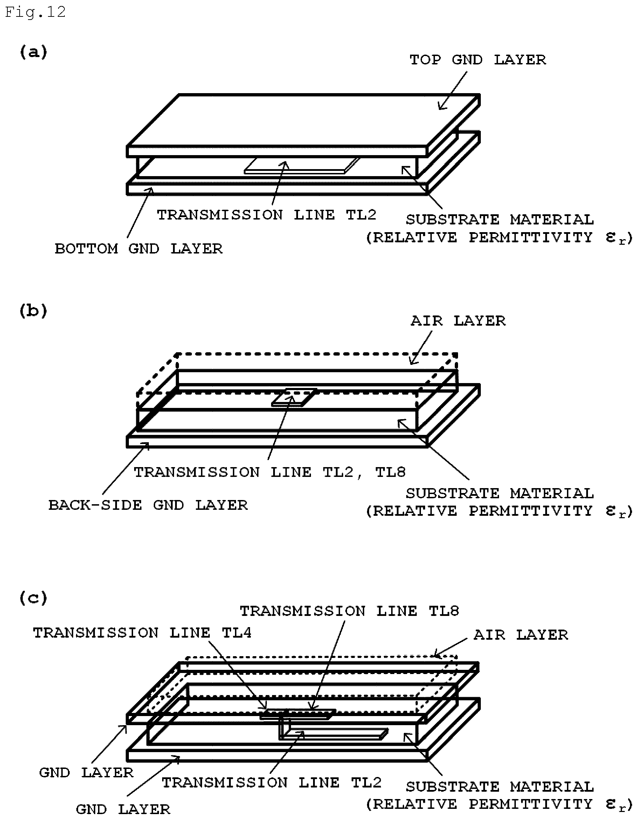

Now, a schematic configuration of a high-frequency amplifier according to the present invention will be described with reference to FIG. 1, a high-frequency amplifier for a class-F amplifier of the invention will be described with reference to FIG. 2, a circuit example of an inductive load will be described with reference to FIG. 3, a high-frequency amplifier for a class-F amplifier by a push-pull configuration will be described with reference to FIGS. 4 to 7, a high-frequency amplifier for an inverse class-F amplifier of the invention will be described with reference to FIG. 8, a circuit example of a capacitive load will be described with reference to FIG 9, a high-frequency amplifier for an inverse class-F amplifier by a push-pull configuration will be described with reference to FIGS. 10 to 11, and a multi-layer configuration of the high-frequency amplifier of the invention will be described with reference to FIG. 12.

### <Schematic Configuration of the Inventio>

Figure 1(a) illustrates the schematic configuration of the high-frequency amplifier of the present invention, FIG. 1(b) shows the schematic configuration of the high-frequency amplifier for the class-F amplifier of the invention, and FIG. 1(c) shows the schematic configuration of the high-frequency amplifier for the inverse class-F amplifier of the invention.

### (Schematic Configuration of High-Frequency Amplifier)

In Figure 1(a), a high-frequency amplifier 1 includes an amplifier 2 that amplifies a high-frequency signal, and an impedance adjustment unit 3 that adjusts an impedance for a high frequency as seen from the amplifier 2 side to a load 6 side. The impedance adjustment unit 3 conducts an adjustment on an impedance for filtering a fundamental wave and harmonics. The impedance adjustment unit 3 does not have a quarter-wavelength transmission line for the fundamental wave, and thus the configuration that does not require the quarter-wavelength transmission line for the fundamental wave can prevent a size increase due to a line length and a conductor width of the quarter-wavelength transmission line for the fundamental wave.

The impedance adjustment unit 3 includes a distributed constant circuit 4 and a lumped constant circuit 5. The distributed constant circuit 4 includes a transmission line having a line length that produces resonance for harmonics. The lumped constant circuit 5 includes a resonance circuit that resonates with harmonics other than harmonics which is subjected to the impedance adjustment by the distributed constant circuit 4, and with a fundamental wave. The transmission line of the distributed constant circuit 4 consists of a transmission line of an open stub having its one end being an open end.

The impedance adjustment unit 3 conducts impedance adjustment using the lumped constant circuit, instead of impedance adjustment using a stub that requires a long line length at the harmonics. Thus, it is not necessary to use a stub requiring the long line length.

### (a) Schematic configuration of high-frequency amplifier for class-F amplifier

In a class-F operation, a half-wave rectified current waveform represented by the composite of the fundamental wave and an even harmonic can be obtained by setting a load impedance for a DC feed circuit and an odd harmonic to a high impedance, and a rectangular voltage waveform represented by the composite of a fundamental wave having a phase opposite to that of the current and an odd harmonic can be obtained by setting the load impedance for the even harmonic to zero. In this case, a product of the current and the voltage is zero, so that the power consumption in a transistor of the amplifier is zero. The impedance condition in the class-F operation is that an impedance for a high frequency as seen from the transistor side to a load side is a short-circuit state at the even harmonics while being a high impedance at the odd harmonics, and the current and voltage of the fundamental wave have the phases opposite to each other.

The class-F amplifier conducts harmonic processing such that the impedance for the high frequency as seen from an output terminal of the transistor side to the load side satisfies the impedance condition in the class-F operation in the impedance adjustment unit.

The schematic configuration of a high-frequency amplifier 1a by the class-F amplifier will be described by referring to FIG. 1(b) .

In the class-F operation by the high-frequency amplifier 1a, the condition of the load impedance for high frequency as seen from the amplifier 2 to the load 6 side is that the impedance is a short-circuit state for the even harmonics and is high for the odd harmonics. The condition that the load impedance is a short-circuit state for the even harmonics is achieved by a distributed constant circuit 4a and the condition that the load impedance is high for the odd harmonics is achieved by a lumped constant circuit 5a.

The distributed constant circuit 4a consists of a transmission line of an open stub having its one end being an open end. The open stub has a line length that produces resonance for the even harmonics, and is for conducting the impedance adjustment to bring the even harmonics into the short-circuit state. The lumped constant circuit 5a consists of a resonance circuit for an inductive load. The resonance circuit conducts the impedance adjustment to bring the odd harmonics into the high impedance state. A matching circuit 8 that conducts matching for the fundamental wave may be provided between the impedance adjustment unit 3 and the load 6.

### (b) Schematic configuration of high-frequency amplifier for inverse class-F amplifier

An impedance condition of an inverse class-F operation is that an impedance for a high frequency as seen from a transistor side to a load side is a short-circuit state for odd harmonics while being high for even harmonics, and a current and a voltage of a fundamental wave have phases opposite to each other.

The inverse class-F amplifier conducts harmonic processing such that an impedance for the high frequency taking into consideration the load side from an output terminal of the transistor satisfies the impedance condition of the inverse class-F operation in the impedance adjustment unit.

The schematic configuration of a high-frequency amplifier 1b by the inverse class-F amplifier will be described by referring to FIG. 1(c).

In the inverse class-F operation by the high-frequency amplifier 1b, the impedance condition for the high frequency as seen from the amplifier 2 to the load 6 side is that the impedance is the short-circuit state for the odd harmonics and is high for the even harmonics.

The condition that the load impedance is the short-circuit state for the odd harmonics is achieved by a distributed constant circuit 4b and the condition that the load impedance is high for the even harmonics is achieved by a lumped constant circuit 5b.

The distributed constant circuit 4b consists of a transmission line of an open stub having its one end being an open end. The open stub has a line length that produces resonance for the odd harmonics, and is for conducting the impedance adjustment to bring the odd harmonics into the short-circuit state. The lumped constant circuit 5b consists of a resonance circuit that is a predetermined inductive load for a fundamental wave and is a capacitive load for the even harmonics. The resonance circuit conducts the impedance adjustment to bring the even harmonics into the high impedance state. A matching circuit 8 that conducts matching for the fundamental wave may be provided between the impedance adjustment unit 3 and the load 6.

### <Configuration Example of High-Frequency Amplifier for Class-F Amplifier>

Figures 2(a) and 2(b) show configuration examples (1A, 1B) of the high-frequency amplifier for the class-F amplifier. A class-F amplifier 1A is configured to conduct the impedance adjustment for a second harmonic by the open stub, and a class-F amplifier 1B is configured to conduct the impedance adjustment for the second harmonic by the lumped constant circuit. Reference sign Lda in the figure indicates a DC inductance and reference sign Cda indicates a DC cut capacitance.

### (a) Class-F amplifier 1A

In Figure 2(a), the class-F amplifier 1A consists of the amplifier 2 and an impedance adjustment unit 3A. The amplifier 2 biases a drain voltage in an LDMOS with a DC voltage Vdc, removes a harmonic component of a resulting rectangular voltage waveform using the impedance adjustment unit 3A and then outputs the voltage to the load 6. The impedance adjustment unit 3A consists of a distributed constant circuit 4A that short-circuits an impedance for an even harmonic to be zero, and a lumped constant circuit 5A that adjusts an impedance to be an inductive load of a high impedance for an odd harmonic. Harmonic processing is conducted to enable an impedance for a high frequency as seen from an output end of the amplifier 2 to the load 6 side to satisfy an impedance condition of the class-F operation.

### (a1) Distributed constant circuit 4A

The distributed constant circuit 4A short-circuits an impedance for an even harmonic by an open stub transmission line. The one end of the open stub is an open end, and a line length is λₙ/4 that is 1/4 of each wavelength λₙ (where n is an even number) of the even harmonic.

When the line length of the open stub is 1/4 of the wavelength λₙ (n is the even number) of the even harmonic, one of the voltage waveforms of the open stub is a node and its value is zero, so that the even harmonic on an output end A side of the amplifier 2, which is opposite to the open end of the open stub, is a short-circuit state.

Even harmonic components become smaller as the order increases, so that the impedance condition of the class-F operation can be satisfied sufficiently by a finite number of even harmonics. In addition to that, the open stub having a line length Lₙ at an n-th harmonic also short-circuits the impedance for a harmonic that is odd multiples of the n-th harmonic, so that a limited number of open stubs can also satisfy the impedance condition of the class-F operation effectively.

For example, when n is 2, 4 and 8, three open stubs having line lengths of L₂, L₄ and L₈, respectively, that corresponds to a second harmonic (frequency f₂), a fourth harmonic (frequency f₄) and an eighth harmonic (frequency f₈), respectively, can be used to short-circuit the impedances for even harmonics of the second harmonic, the fourth harmonic, a sixth harmonic, the eighth harmonic, a tenth harmonic and a twelfth harmonic.

The line length L₂ of the open stub for the second harmonic is λ₂/4 that is 1/4 of the wavelength λ₂, and is one-half of a quarter-wavelength λ₁/4 of the wavelength λ₁ of the fundamental wave.

The line length L₄ of the open stub for the fourth harmonic is λ₄/4 that is 1/4 of the wavelength λ₄, and is one-quarter of the quarter-wavelength λ₁/4 of the wavelength λ₁ of the fundamental wave.

The line length L₈ of the open stub for the eighth harmonic is λ₈/4 that is 1/4 of the wavelength λ₈, and is one-eighth of the quarter-wavelength λ₁/4 of the wavelength λ₁ of the fundamental wave.

The open stub having the line length L₂ for the second harmonic also short-circuits the impedance for the sixth harmonic which is three times the second harmonic and the tenth harmonic which is five times the second harmonic, in addition to the second harmonic. The open stub having the line length L₄ for the fourth harmonic also short-circuits the twelfth harmonic which is three times the fourth harmonic and a twentieth harmonic which is five times the fourth harmonic, in addition to the fourth harmonic. The open stub having the line length L₈ for the eighth harmonic also short-circuits a twenty-fourth harmonic which is three times the eighth harmonic and a fortieth harmonic which is five times the eighth harmonic, in addition to the eighth harmonic.

In this way, the three open stubs having the line length L₂, L₄ and L₈ for the second harmonic, the fourth harmonic and the eighth harmonic, respectively, can be used to short-circuit the impedances for the even harmonics of the second harmonic, the fourth harmonic, the sixth harmonic, the eighth harmonic, the tenth harmonic and the twelfth harmonic.

### (a2) Lumped constant circuit 5A

The lumped constant circuit 5A uses an inductive load to obtain a high impedance for an odd harmonic. The inductive load consists of a series-connected inductor Lf and a capacitor Cf connected to the load in parallel. The inductive load of the LC circuit sets an impedance for a fundamental wave at a frequency f₁ to be a predetermined inductive load to thereby obtain an inductive high impedance for the odd harmonic.

### (b) Class-F amplifier 1B

In the configuration example of the class-F amplifier 1A shown in FIG. 2(a), the distributed constant circuit 4A uses the transmission lines of the open stubs to short-circuit the impedances for the second harmonic, the fourth harmonic and the eighth harmonic. By contrast, the configuration example of the class-F amplifier 1B shown in FIG. 2(b) replaces a part of the transmission lines in the distributed constant circuit 4A with the lumped constant circuit. The amplifier 2 may have the same configuration as that of the class-F amplifier 1A.

### (b1) Distributed constant circuit 4B

An impedance adjustment unit 3B consists of a distributed constant circuit 4B that short-circuits an impedance for an even harmonic to be zero, a lumped constant circuit 5Ba that defines an impedance of a fundamental wave as a predetermined inductive load and adjusts an impedance for an odd harmonic to be an inductive high impedance, and a lumped constant circuit 5Bb that short-circuits the impedance for the even harmonic (the second harmonic in FIG. 2(b)). Thus, the impedance adjustment unit 3B conducts harmonic processing so that an impedance for a high frequency as seen form an output end of the amplifier 2 to a load 6 side satisfies the impedance condition of the class-F operation.

Among the open stubs for short-circuiting the impedance for the even harmonics, the open stub having the longest line length is used for the second harmonic. The distributed constant circuit 4B has a configuration in which an open stub for the sixth harmonic is added, except for the open stub for the second harmonic included in the distributed constant circuit 4A of the class-F amplifier 1A.

### (b2) Lumped constant circuit 5B

On the other hand, the lumped constant circuit 5B includes the lumped constant circuit 5Ba that adjusts the impedance for the odd harmonic to be an inductive high impedance, and the lumped constant circuit 5Bb that short-circuits the second harmonic. The lumped constant circuit 5Bb is an alternative to the transmission line of the open stub for the second harmonic removed from the distributed constant circuit 4B. The lumped constant circuit 5Bb consists of a series circuit formed of an inductor Lf2 and a capacitor Cf2, and is configured to short-circuit the second harmonics. The class-F amplifier 1B can be reduced in circuit size by eliminating the open stub having the long line length.

In a case where the frequency of the fundamental wave is low, the line length becomes also longer in the open stub for short-circuiting the impedance for the even harmonics, so that the circuit size can be reduced by further replacing the open stub having the long line length with the lumped constant circuit for a higher even harmonic.

### <Form Example of Inductive Load>

Form Examples 1 to 4 of the inductive load will be described by referring to FIG. 3.

### (a) Form Example 1

The inductive load according to Form Example 1 consists of a leakage inductance Le of an output transformer 17A and the capacitor Cf connected in parallel on the secondary side of the output transformer 17A. When a coupling coefficient k of the output transformer 17A and the sum of self/mutual inductances of the output transformer is indicated with L, the leakage inductance Le is expressed by Le=(1-k)L.

### (b) Form Example 2

The inductive load according to Form Example 2 consists of the inductors Lf connected in series on the primary side of an output transformer 17B and the capacitor Cf connected in parallel on the secondary side of the output transformer 17B.

### (c) Form Example 3

The inductive load according to Form Example 3 consists of the inductors Lf connected in series on the primary side of an output transformer 17C and the capacitor Cf connected in parallel on the primary side of the output transformer 17C.

### (d) Form Example 4

The inductive load according to Form Example 4 consists of the inductor Lf connected in series on the secondary side of an output transformer 17D and the capacitor Cf connected in parallel on the secondary side of the output transformer 17D.

### <High-Frequency Amplifier in Push-Pull Configuration by Class-F Amplifier>

The high-frequency amplifier of the invention has a push-pull configuration using two amplifiers for amplifying high-frequency signals having phases opposite to each other, and can obtain a high-power output with small distortion. The two amplifiers with the pull-push configuration of the class-F amplifier are connected to a load through an output transformer. Now, configuration examples will be presented that employ the above-described Form Examples of the inducive load in the high-frequency amplifier with the push-pull configuration by the class-F amplifier.

### (a) Configuration Example 1

Figure 4 shows Configuration Example 1 of the high-frequency amplifier. Configuration Example 1 employs the above-described Form Example 1 of the inductive load.

A high-frequency amplifier 11A according to Configuration Example 1 includes an amplifier 12A and an impedance adjustment unit 13A, the amplifier 12A and the impedance adjustment unit 13A being paired to form a push-pull circuit.

The amplifier 12A includes two amplifiers (LDMOSs) of an amplifier 12Aa and an amplifier 12Ab. The amplifier 12Aa and the amplifier 12Ab are biased by a DC voltage Vdc via an inductor of an output transformer 17A, and input high-frequency signals, whose phases are opposite to each other, as gate signals to thereby conduct amplification operations in opposite phases to each other. The amplifier 12A may be formed by arranging the two amplifiers of the amplifier 12Aa and the amplifier 12Ab in one package.

A distributed constant circuit 14A, which constitutes the impedance adjustment unit 13A, includes two distributed constant circuits of a distributed constant circuit 14Aa and a distributed constant circuit 14Ab that are configured to short-circuit even harmonics. The distributed constant circuit 14Aa and the distributed constant circuit 14Ab are paired to form a push-pull circuit, each circuit including a plurality of open stubs for short-circuiting even harmonics. In Configuration Example 1 shown in FIG. 4, both of the distributed constant circuit 14Aa and the distributed constant circuit 14Ab include three open stubs, i.e., an open stub with a line length of λ₂/4 for short-circuiting a second harmonic, an open stub with a line length of λ₄/4 for short-circuiting a fourth harmonic, and an open stub with a line length of λ₈/4 for short-circuiting an eighth harmonic.

A lumped constant circuit 15A, which constitutes the impedance adjustment unit 13A, is composed of a leakage inductance of the output transformer 17A and the capacitor Cf connected in parallel to a secondary coil, and forms an inductive load for conducting impedance adjustment to obtain a high impedance for an odd harmonic.

The impedance adjustment unit 13A has its output end connected to a load 16A via a matching circuit 18A. The matching circuit 18A is for conducting matching for the fundamental wave and consists of an inductor Lo that is connected in series on the secondary side of the output transformer 17A and a capacitor Co that is connected in parallel with respect to the load. The figure shows the load 16A of 50 ohm which is just one example and is not limited thereto.

### (b) Configuration Example 2

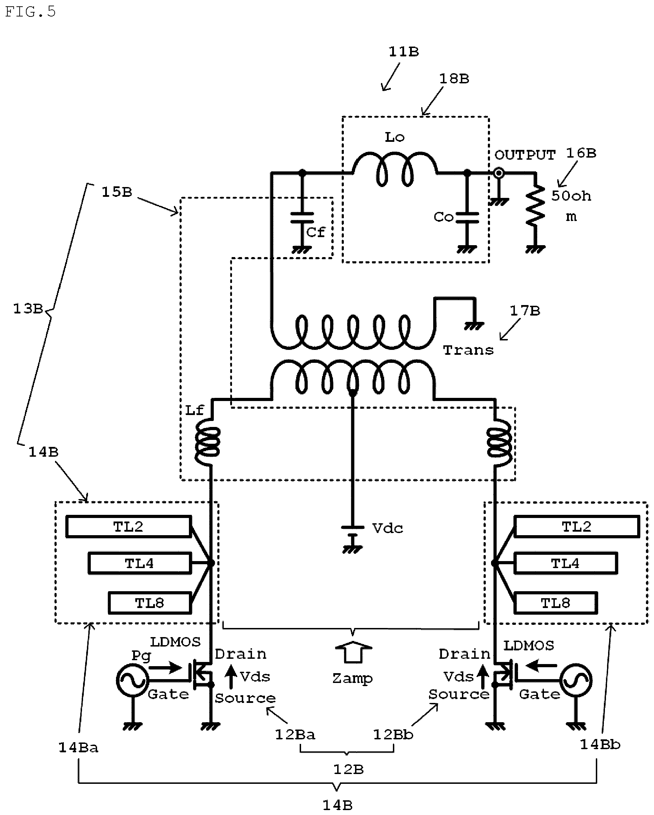

Figure 5 shows Configuration Example 2 of the high-frequency amplifier. Configuration Example 2 employs the aforementioned Form Example 2 of the inductive load.

A high-frequency amplifier 11B according to Configuration Example 2 includes an amplifier 12B and an impedance adjustment unit 13B, the amplifier 12B and the impedance adjustment unit 13B being paired to form a push-pull circuit.

The amplifier 12B includes two amplifiers (LDMOSs) of an amplifier 12Ba and an amplifier 12Bb. The amplifier 12Ba and the amplifier 12Bb are biased by a DC voltage Vdc via an inductor of an output transformer 17B, and input high-frequency signals, whose phases are opposite to each other, as gate signals to thereby conduct amplification operations in opposite phases to each other. The amplifier 12B may be formed by arranging the two amplifiers of the amplifier 12Ba and the amplifier 12Bb in one package.

A distributed constant circuit 14B, which constitutes the impedance adjustment unit 13B, includes two distributed constant circuits of a distributed constant circuit 14Ba and a distributed constant circuit 14Bb that are configured to short-circuit even harmonics. The distributed constant circuit 14Ba and the distributed constant circuit 14Bb are paired to form a push-pull circuit, each circuit including a plurality of open stubs for short-circuiting even harmonics. In Configuration Example 2 shown in FIG. 5, both of the distributed constant circuit 14Ba and the distributed constant circuit 14Bb include three open stubs, i.e., an open stub with a line length of λ₂/4 for short-circuiting a second harmonic, an open stub with a line length of λ₄/4 for short-circuiting a fourth harmonic, and an open stub with a line length of λ₈/4 for short-circuiting an eighth harmonic.

A lumped constant circuit 15B, which constitutes the impedance adjustment unit 13B, is composed of an inductor Lf connected in series on the primary side of the output transformer 17B and the capacitor Cf connected in parallel on the secondary side of the output transformer 17A, and forms an inductive load for conducting impedance adjustment to obtain a high impedance for an odd harmonic.

The impedance adjustment unit 13B has its output end connected to a load 16B via a matching circuit 18B. The matching circuit 18B is for conducting matching for a fundamental wave and consists of the inductor Lo that is connected in series on the secondary side of the output transformer 17B and the capacitor Co that is connected in parallel with respect to the load. The figure shows the load 16B of 50 ohm which is just one example and is not limited thereto.

### (c) Configuration Example 3

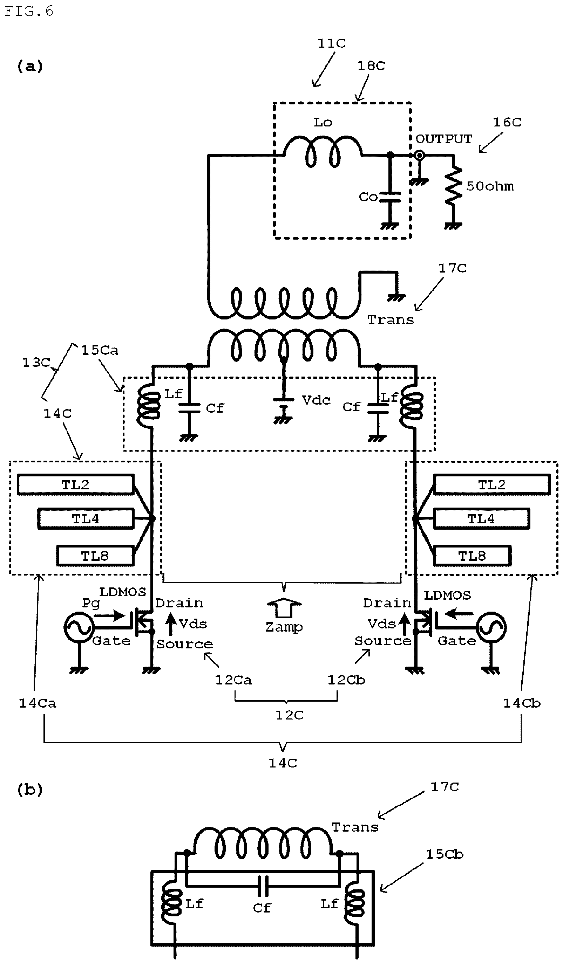

Figure 6 shows Configuration Example 3 of the high-frequency amplifier. Configuration Example 3 employs the aforementioned Form Example 3 of the inductive load.

A high-frequency amplifier 11C according to Configuration Example 3 includes an amplifier 12C and an impedance adjustment unit 13C, the amplifier 12C and the impedance adjustment unit 13C being paired to form a push-pull circuit.

The amplifier 12C includes two amplifiers (LDMOSs) of an amplifier 12Ca and an amplifier 12Cb. The amplifier 12Ca and the amplifier 12Cb are biased by a DC voltage Vdc via an inductor of an output transformer 17C, and input high-frequency signals, whose phases are opposite to each other, as gate signals to thereby conduct amplification operations in opposite phases to each other. The amplifier 12C may be formed by arranging the two amplifiers of the amplifier 12Ca and the amplifier 12Cb in one package.

A distributed constant circuit 14C, which constitutes the impedance adjustment unit 13C, includes two distributed constant circuits of a distributed constant circuit 14Ca and a distributed constant circuit 14Cb that are configured to short-circuit even harmonics. The distributed constant circuit 14Ca and the distributed constant circuit 14Cb are paired to form a push-pull circuit, each circuit including a plurality of open stubs for short-circuiting even harmonics. In Configuration Example 3 shown in FIG. 6, both of the distributed constant circuit 14Ca and the distributed constant circuit 14Cb include three open stubs, i.e., an open stub with a line length of λ₂/4 for short-circuiting a second harmonic, an open stub with a line length of λ₄/4 for short-circuiting a fourth harmonic, and an open stub with a line length of λ₈/4 for short-circuiting an eighth harmonic.

A lumped constant circuit 15Ca, which constitutes the impedance adjustment unit 13C, is composed of the inductor Lf connected in series on the primary side of the output transformer 17C and a capacitor Cf connected in parallel between the primary side of the output transformer 17C and a grounding end (GND), and forms an inductive load for conducting impedance adjustment to obtain a high impedance for an odd harmonic. In addition to that, as shown in FIG. 6(b), a capacitor Cf of a lumped constant circuit 15Cb may be connected in parallel with respect to a primary coil of the output transformer 17C.

The impedance adjustment unit 17C has its output end on the secondary side connected to a load 16C via a matching circuit 18C. The matching circuit 18C is for conducting matching for a fundamental wave and consists of an inductor Lo that is connected in series and a capacitor Co that is connected in parallel. The figure shows the load 16C of 50 ohm which is just one example and is not limited thereto.

### (d) Configuration Example 4

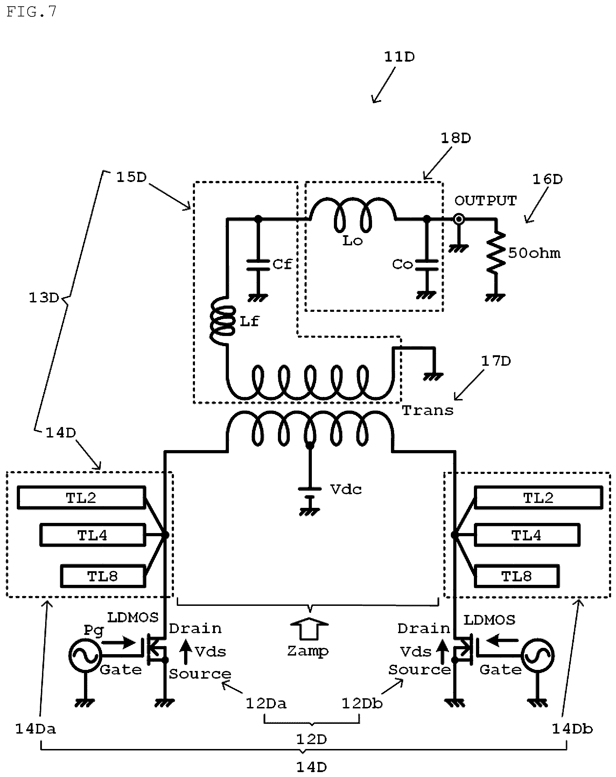

Figure 7 shows Configuration Example 4 of the high-frequency amplifier. Configuration Example 4 employs the aforementioned Form Example 4 of the inductive load.

A high-frequency amplifier 11D according to Configuration Example 4 includes an amplifier 12D and an impedance adjustment unit 13D, the amplifier 12D and the impedance adjustment unit 13D being paired to form a push-pull circuit.

The amplifier 12D includes two amplifiers (LDMOSs) of an amplifier 12Da and an amplifier 12Db. The amplifier 12Da and the amplifier 12Db are biased by a DC voltage Vdc via an inductor of an output transformer 17D, and input high-frequency signals, whose phases are opposite to each other, as gate signals to thereby conduct amplification operations in opposite phases to each other. The amplifier 12D may be formed by arranging the two amplifiers of the amplifier 12Da and the amplifier 12Db in one package.

A distributed constant circuit 14D, which constitutes the impedance adjustment unit 13D, includes two distributed constant circuits of a distributed constant circuit 14Da and a distributed constant circuit 14Db that are configured to short-circuit even harmonics. The distributed constant circuit 14Da and the distributed constant circuit 14Db are paired to form a push-pull circuit, each circuit including a plurality of open stubs for short-circuiting even harmonics. In the configuration example shown in FIG. 7, both of the distributed constant circuit 14Da and the distributed constant circuit 14Db include three open stubs, i.e., an open stub with a line length of λ₂/4 for short-circuiting a second harmonic, an open stub with a line length of λ₄/4 for short-circuiting a fourth harmonic, and an open stub with a line length of λ₈/4 for short-circuiting an eighth harmonic.

A lumped constant circuit 15D, which constitutes the impedance adjustment unit 13D, is composed of an inductor Lf connected in series on the secondary side of the output transformer 17D and a capacitor Cf connected in parallel on the secondary side of the output transformer 17D, and forms an inductive load for conducting impedance adjustment to obtain a high impedance for an odd harmonic.

The impedance adjustment unit 13D has its output end connected to a load 16D via a matching circuit 18D. The matching circuit 18D is for conducting matching for a fundamental wave and consists of an inductor Lo that is connected in series and a capacitor Co that is connected in parallel with respect to the load. The figure shows the load 16D of 50 ohm which is just one example and is not limited thereto.

### <Configuration Example of High-Frequency Amplifier by Inverse Class-F Amplifier>

Figures 8(a) and 8(b) show configuration examples (1C, 1D) of a high-frequency amplifier by an inverse class-F amplifier. Configuration Example 1C is for conducting impedance adjustment for a third harmonic by an open stub, and Configuration Example 1D is for conducting the impedance adjustment for the third harmonic by a lumped constant circuit. Reference letter Lda in the figure indicates a DC inductance, and reference letter Cda indicates a DC cut capacity.

### (a) Inverse class-F amplifier 1C

In Figure 8(a), an inverse class-F amplifier 1C consists of an amplifier 2 and an impedance adjustment unit 3C. The amplifier 2 biases a drain voltage of an LDMOS with a DC voltage Vdc, removes a harmonic component of resulting rectangular current waveform using the impedance adjustment unit 3C and then outputs the processed voltage to a load 6.

The impedance adjustment unit 3C consists of a distributed constant circuit 4C that short-circuits an impedance to be zero for an odd harmonic and a lumped constant circuit 5C, which is a capacitive load, that adjusts an impedance to be high for an even harmonic and adjusts the impedance to be a predetermined inductive load for a fundamental wave. Harmonic processing is conducted such that an impedance for a high frequency as seen from an output end of the amplifier 2 to a load 6 side satisfies an impedance condition of an inverse class-F operation.

### (a1) Distributed constant circuit 4C

The distributed constant circuit 4C short-circuits an impedance for an odd harmonic by using a transmission line of the open stub. One end of the open stub is an open end, and the line length is λₙ/4 that is 1/4 of each wavelength λₙ (where n is an odd number) of the odd harmonic.

When the line length of the open stub is 1/4 of the wavelength λₙ (where n is the odd number) of the odd harmonic, a voltage waveform at the open end of the open stub is an antinode and in an open state, so that the odd harmonic at an open end A of the amplifier 2, which is a connecting end to the open stub, is in a short-circuit state.

Odd harmonic components become smaller at higher order, so that a finite number of odd harmonics are sufficient to satisfy the impedance condition of the inverse class-F operation.

For example, when n is 3, 5 and 7, three open stubs having line length L₃, L₅ and L₇ corresponding to a third harmonic (frequency f₃), a fifth harmonic (frequency f₅) and a seventh harmonic (frequency f₇), respectively, are used to short-circuit impedances for odd harmonics of the third harmonic, the fifth harmonic and the seventh harmonic.

An open stub having a line length Lₙ for a n-th harmonic can short-circuit an impedance for a harmonic that is an odd multiple of the n-th harmonic, so that even a limited number of open stubs can effectively satisfy the impedance condition of the inverse class-F amplifier.

The line length L₃ of the open stub for the third harmonic has λ₃/4 wavelength that is 1/4 of a wavelength λ₃, and is one third of a quarter-wavelength λ₁/4 of the wavelength λ₁ of the fundamental wave.

The line length L₅ of the open stub for the fifth harmonic has λ₅/4 wavelength that is 1/4 of a wavelength of λ₅, and is one fifth of the quarter-wavelength λ₁/4 of the wavelength λ₁ of the fundamental wave.

The same is true for the line length L₇ of the open stub for the seventh harmonic, it is one seventh of the quarter-wavelength λ₁/4 of the wavelength λ₁ of the fundamental wave.

Since the open stub having the line length Lₙ for the n-th harmonic can short-circuit the impedance for the harmonic that is the odd multiple of the n-th harmonic, even the limited number of open stubs can effectively satisfy the impedance condition of the inverse class-F operation. The use of the odd multiple relation of the harmonic can omit an open stub for a nineth harmonic by using the open stub for the third harmonic. That is to say, the three open stubs having the line length L₃, L₅ and L₇ corresponding to the third harmonic, the fifth harmonic and the seventh harmonic, respectively, can be used to short-circuit impedances for the odd harmonics of the third harmonic, the fifth harmonic, the seventh harmonic and the nineth harmonic.

### (a2) Lumped constant circuit 5C

The lumped constant circuit 5C is a capacitive load, and is composed of an inductor Lf connected in series to a load and a capacitor Cf connected in parallel to the load, and is configured to adjust an impedance to be high for an even harmonic while adjusting the impedance to be a predetermined inductive load for the fundamental wave. The capacitor Cf may be connected in series between the output end A and a grounding end, as shown in the figure with a broken line.

### (b) Inverse class-F amplifier 1D

In Figure 8(b), an inverse class-F amplifier 1D consists of an amplifier 2 and an impedance adjustment unit 3D. The amplifier 2 biases a drain voltage of an LDMOS with a DC voltage Vdc, removes a harmonic component contained in a rectangular current waveform using the impedance adjustment unit 3D, and then outputs the processed voltage to a load 6.

In the configuration example of the inverse class-F amplifier 1C shown in FIG. 8(a), the transmission lines of the open stubs are used for short-circuiting the impedances for the third harmonic, the fifth harmonic and the seventh harmonic. By contrast, the configuration example of the inverse class-F amplifier 1D shown in FIG. 8(b) uses a lumped constant circuit in place of the transmission line of the open stub for the impedance for the third harmonic among the transmission lines included in the distributed constant circuit 4C in the configuration example of the inverse class-F amplifier 1C, and uses a distributed constant circuit 4D of a transmission line of an open stub for the remaining impedances for the fifth harmonic, the seventh harmonic and the nineth harmonic, as with the configuration example of the inverse class-F amplifier 1C. The amplifier 2 can have the same configuration as that of the inverse class-F amplifier 1C.

### (b1) Impedance adjustment unit 3D

In the configuration example of the inverse class-F amplifier 1D shown in FIG. 8(b), the impedance adjustment unit 3D consists of a distributed constant circuit 4D that short-circuits, among impedances as seen from an output end A to a load 6 side, impedances for odd harmonics (a fifth harmonic, a seventh harmonic and a nineth harmonic) to be zero, a capacitive load 5Da that opens and adjusts an impedance to be high for an even harmonic while adjusting the impedance to be a predetermined inductive load for a fundamental wave, and a series-resonant circuit 5Db that short-circuits an impedance for a third harmonic. Harmonic processing is conducted such that an impedance for a high frequency as seen from the output end A of the amplifier 2 to the load 6 side satisfies an impedance condition of an inverse class-F operation. In this case, the capacitive load 5Da and the series-resonant circuit 5Db form a lumped constant circuit 5D.

### (b2) Distributed constant circuit 4D

Among the open stubs for short-circuiting impedances for odd harmonics, the open stub having the longest line length is used for the third harmonic. The distributed constant circuit 4D has the configuration of the distributed constant circuit 4C of the inverse class-F amplifier 1C excluding the open stub for the third harmonic, so that the open stub having the long line length is omitted to reduce the circuit size.

The distributed constant circuit 4D short-circuits the impedances for the odd harmonics by the transmission lines of the open stubs, as with the distributed constant circuit 4C. One end of each open stub is an open end, and a line length is λₙ/4 that is 1/4 of each wavelength λₙ (where n is an odd number) of the odd harmonic. Since the distributed constant circuit 4D has no open stub for the third harmonic, it includes an open stub for the nineth harmonic which is omitted in the distributed constant circuit 4C, in addition to the open stubs for the fifth harmonic and the seventh harmonic.

When the line length of the open stub is 1/4 of the wavelength λₙ (where n is the odd number) of the odd harmonic, a voltage waveform at the open end of the open stub is an antinode and in an open state, so that the odd harmonic at the open end A of the amplifier 2, which is a connecting end to the open stub, is in a short-circuit state.

### (b3) Lumped constant circuit 5D

The lumped constant circuit 5D includes the capacitive load 5Da and the series-resonant circuit 5Db. The capacitive load 5Da is a capacitive load that consists of an inductor Lf connected in series to the load and a capacitor Cf connected in parallel to the load, and is configured to adjust an impedance to be high for an even harmonic while adjusting the impedance to be a predetermined inductive load for a fundamental wave.

The capacitor Cf may be connected in series between the open end A and a grounding end, as shown in the figure with a broken line. The series-resonant circuit 5Db consists of a series circuit formed by an inductor Lf3 and a capacitor Cf3, and uses the lumped constant circuit in place of the transmission line of the open stub for the third harmonic to thereby short-circuit an impedance for the third harmonic at a frequency f3.

The circuit size of the inverse class-F amplifier 1D can be reduced by removing the open stub having the long line length. Since the line length of the open stub for short-circuiting the impedance for the odd harmonic is long when the frequency of the fundamental wave is low, the open stub having the long line length is replaced with the lumped constant circuit even for a higher odd harmonic to achieve the reduction in the circuit size.

### <Form Example of Capacitive Load>

Form Examples 1 and 2 of the capacitive load will be described by referring to FIG. 9. FIGS. 9(a) to 9(c) show Form Example 1 and FIG. 9(d) shows Form Example 2.

### (a) Form Example 1

The capacitive load in Form Example 1 consists of an inductor Lf connected in series to a coil of an output transformer 17E and a capacitor Cf connected in parallel to a primary coil of the output transformer 17E. FIG. 9(a) shows a configuration example in which the inductor Lf is connected in series to the primary coil of the output transformer 17E, and FIG. 9(b) shows a configuration example in which the inductor Lf is connected in series to a secondary coil of the output transformer 17E. FIG. 9(c) shows a configuration example in which the inductor Lf is connected in series to the primary coil of the output transformer 17E and the capacitor Cf is connected to grounding ends at both ends of the primary coil. As the inductor Lf, a leakage inductor of the transformer may be used.

### (b) Form Example 2

The capacitive load in Form Example 2 consists of an inductor Lf connected in series and a capacitor Cf connected in parallel to a coil of an output transformer 17F on the secondary side of the output transformer 17F. FIG. 9(d) shows Form Example 2.

### <High-Frequency Amplifier in Push-Pull Configuration by Inverse Class-F Amplifier>

The high-frequency amplifier of the present invention also has a push-pull configuration for the inverse class-F amplifier that uses two amplifiers for amplifying high-frequency signals having phases opposite to each other, so as to be able to obtain high-power output with small distortion. The two amplifiers in the push-pull configuration of the inverse class-F amplifier are connected to a load via an output transformer. Configuration examples will be presented below in which the above-described form examples of the inductive load are applied to the high-frequency amplifier in the push-pull configuration by the inverse class-F amplifier.

### (a) Configuration Example 5

Figure 10 shows Configuration Example 5 of the high-frequency amplifier. Configuration Example 5 shows a configuration that employs Form Example 1 of the capacitive load. The illustrated configuration shows that the inductor Lf is provided on both ends of the output transformer 17E.

A high-frequency amplifier 11E of Configuration Example 5 includes an amplifier 12E and an impedance adjustment unit 13E, and the amplifier 12E and the impedance adjustment unit 13E are paired to form a push-pull circuit.

The amplifier 12E includes two amplifiers (LDMOSs) of an amplifier 12Ea and an amplifier 12Eb. The amplifier 12Ea and the amplifier 12Eb are biased by a DC voltage Vdc via an inductor on the primary side of an output transformer 17E. High-frequency signals, whose phases are opposite to each other, are applied as gate signals to the amplifier 12Ea and the amplifier 12Eb so that the amplifiers conduct amplification operations in opposite phases to each other to thereby conduct push-pull operations.

The impedance adjustment unit 13E includes a distributed constant circuit 14E and a lumped constant circuit 15E. The distributed constant circuit 14E includes two distributed constant circuits of a distributed constant circuit 14Ea and a distributed constant circuit 14Eb that are configured to short-circuit odd harmonics. The distributed constant circuit 14Ea and the distributed constant circuit 14Eb are paired to form a push-pull circuit, each circuit including a plurality of open stubs for short-circuiting the odd harmonics. In Configuration Example 5 shown in FIG. 10, the distributed constant circuit 14Ea and the distributed constant circuit 14Eb include three open stubs, i.e., an open stub with a line length of λ₃/4 for short-circuiting a third harmonic, an open stub with a line length of λ₅/4 for short-circuiting a fifth harmonic, and an open stub with a line length of λ₇/4 for short-circuiting a seventh harmonic.

The lumped constant circuit 15E consists of an inductor Lf connected in series and a capacitor Cf connected in parallel on the primary side of the output transformer 17E, and forms a predetermined inductive load for a fundamental wave and a capacitive load conducting impedance adjustment to adjust an impedance to be high for an even harmonic.

The impedance adjustment unit 13E has its output end connected to a load 16E via a matching circuit 18E. The matching circuit 18E is for conducting matching for the fundamental wave and consists of a series-connected inductor Lo and a parallel-connected capacitor Co. The figure shows the load 16E of 50 ohm which is just one example and is not limited thereto.

### (b) Configuration Example 6

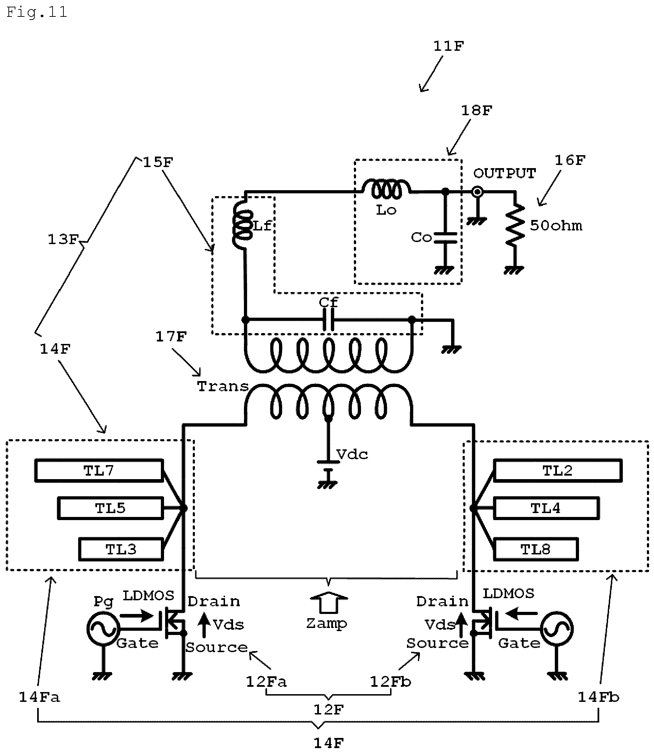

Figure 11 shows Configuration Example 6 of the high-frequency amplifier. Configuration Example 6 employs Form Example 2 of the capacitive load.

A high-frequency amplifier 11F of Configuration Example 6 includes an amplifier 12F and an impedance adjustment unit 13F, and the amplifier 12F and the impedance adjustment unit 13F are paired to form a push-pull circuit. The high-frequency amplifier 11F has the same configuration as that of the high-frequency amplifier 11E, except for the form of the lumped constant circuit 15F that forms the capacitive load.

The amplifier 12F includes two amplifiers (LDMOSs) of an amplifier 12Fa and an amplifier 12Fb. The amplifiers 12Fa and 12Fb are biased by a DC voltage Vdc via an inductor on the primary side of an output transformer 17F. High-frequency signals, whose phases are opposite to each other, are applied as gate signals to the amplifier 12Fa and the amplifier 12Fb so that the amplifiers conduct amplification operations in opposite phases to each other to thereby conduct push-pull operations.

The impedance adjustment unit 13F includes a distributed constant circuit 14F and a lumped constant circuit 15F. The distributed constant circuit 14F includes two distributed constant circuits of a distributed constant circuit 14Fa and a distributed constant circuit 14Fb that are configured to short-circuit odd harmonics. The distributed constant circuit 14Fa and the distributed constant circuit 14Fb are paired to form a push-pull circuit, each circuit including a plurality of open stubs for short-circuiting the odd harmonics. In Configuration Example 6 shown in FIG. 11, the distributed constant circuit 14Fa and the distributed constant circuit 14Fb include three open stubs, i.e., an open stub with a line length of λ₃/4 for short-circuiting a third harmonic, an open stub with a line length of λ₅/4 for short-circuiting a fifth harmonic, and an open stub with a line length of λ₇/4 for short-circuiting a seventh harmonic.

The lumped constant circuit 15F consists of an inductor Lf connected in series and a capacitor Cf connected in parallel on the secondary side of the output transformer 17F, and forms a predetermined inductive load for a fundamental wave and a capacitive load conducting impedance adjustment to adjust an impedance to be high for an even harmonic.

The impedance adjustment unit 13F has its output end connected to a load 16F via a matching circuit 18F. The matching circuit 18F is for conducting matching for the fundamental wave and consists of a series-connected inductor Lo and a parallel-connected capacitor Co. The figure shows the load 16F of 50 ohm which is just one example and is not limited thereto. The inductor Lf may be included in the inductor Lo.

### <Multi-layer Structure of High-Frequency Amplifier>

The high-frequency amplifier of the present invention is configured by applying a multi-layer structure, in which a transmission line of a distributed constant circuit is disposed on a multi-layer substrate constituting the multi-layer structure. A strip-line structure and a microstrip-line structure can be used as multi-layer structures. FIG. 12 shows a configuration example of the multi-layer substrate.

### (a) Strip-line structure

A multi-layer substrate shown in FIG. 12(a) is a strip-line structure in which top and bottom layers are GND layers and a substrate material is sandwiched as a middle layer between the top and bottom GND layers, and a transmission line is disposed on the middle layer. In the strip-line structure, a wavelength shortening rate vf (=1/√εᵣ) depends on a relative permittivity ε_{Γ} of the substrate material, so that a high-dielectric substrate material can be used to shorten the length of the transmission line. In the high-frequency amplifier of the invention, a transmission line TL2 of an open stub for a second harmonic has the longest line length, and thus the transmission line TL2 is disposed in the substrate material of the middle layer in the strip-line structure to thereby contribute to reduce the circuit size.

### (b) Microstrip-line structure

A multi-layer substrate shown in FIG. 12(b) is a microstrip-line structure having a GND layer on its back side and a substrate material provided on an upper layer of the GND layer, in which transmission lines are disposed in the substrate material and on an air layer which is a surface layer on the substrate.

In the microstrip-line structure, an effective relative permittivity εᵣ' of the air layer and the substrate is 0.6 to 0.8 times the relative permittivity εᵣ of the substrate material, so that the line length is longer than that in the strip-line structure. On the other hand, the line length of the transmission lines TL4 and TL8 of the open stubs for a fourth harmonic and an eighth harmonic are shorter than the line length of the transmission line TL for the second harmonic, so that the line length of the transmission lines TL4 and TL8 do not exceed the line length of the transmission line TL for the second harmonic in the microstrip-line structure in which the transmission line is disposed in the air layer having the small effective relative permittivity εᵣ', and thereby the effect on the reduction in the circuit size is small.

### (c) Multi-layer structure

Figure 12(c) shows a multi-layer structure in which a strip-line structure and a microstrip-line structure are stacked.

In the multi-layer structure, a multi-layer is formed by stacking the strip-line structure, in which a substrate material is sandwiched between a top GND layer and a bottom GND layer and a transmission line TL2 having a long line length is disposed in the board material, and the microstrip-line structure, in which the top GND layer in the strip-line structure serves as a back-side GND layer, and transmission lines TL4 and TL8 having a short line length are disposed on the top surface of the substrate material on the back-side GND layer. The transmission line TL2 is connected to the transmission lines TL4 and TL8 through a multilayer through-via hole.

The above-described embodiments and variations are some examples of the wide-band RF power source of the present invention, and the present invention is not limited thereto. The present invention can be varied based on the gist of the invention, and the variations will not be excluded from the scope of the invention.

### [INDUSTRIAL APPLICABILITY]

The high-frequency amplifier of the present invention can be applied to a high-frequency power source (RF generator) which is used for, such as, a semiconductor manufacturing device and a liquid crystal panel manufacturing device.

### [REFERENCE SIGNS LIST]

1, 1a, 1b High-Frequency Amplifier
1A, 1B Class-F Amplifier
1C Inverse Class-F Amplifier
1D Inverse Class-F Amplifier
2 Amplifier
3, 3A, 3B, 3C, 3D Impedance Adjustment Unit
4, 4A, 4B, 4C, 4D Distributed Constant Circuit
4a, 4b Distributed Constant Circuit
5, 5A, 5B, 5C, 5D Lumped Constant Circuit
5Ba, 5Bb Lumped Constant Circuit
5Da Capacitive Load
5Db Series-Resonant Circuit
5a Lumped Constant Circuit
5b Lumped Constant Circuit
6 Load
8 Matching Circuit
11A, 11B, 11C, 11D, 11E, 11F High-Frequency Amplifier
12A, 12B, 12C, 12D, 12E, 12F Amplifier
12Aa, 12Ab Amplifier
12Ba, 12Bb Amplifier
12Ca, 12Cb Amplifier
12Da, 12Db Amplifier
12Ea, 12Eb Amplifier
12Fa, 12Fb Amplifier
13A, 13B, 13C, 13D, 13E, 13F Impedance Adjustment Unit
14A, 14B, 14C, 14D, 14E, 14F Distributed Constant Circuit
14Aa, 14Ab Distributed Constant Circuit
14Ba, 14Bb Distributed Constant Circuit
14Ca, 14Cb Distributed Constant Circuit
14Da, 14Db Distributed Constant Circuit
14Ea, 14Eb Distributed Constant Circuit
14Fa, 14Fb Distributed Constant Circuit
15A, 15B, 15C, 15D, 15E, 15F Lumped Constant Circuit
16A, 16B, 16C, 16D, 16E, 16F Load
17A, 17B, 17C, 17D, 17E, 17F Output Transformer
18A, 18B, 18C, 18D, 18E, 18F Matching Circuit
101A, 101B Class-F Amplifier
102A, 102B Direct Current Feed Circuit
103A, 103B Transmission Line
104A Parallel-Resonant Circuit
104B Series-Resonant Circuit
106A, 106B LOAD
TL, TL2, TL4, TL8 Transmission Line

## Claims

1. A high-frequency amplifier, comprising:
an amplifier that amplifies a high-frequency signal; and
an impedance adjustment unit that adjusts an impedance for a high frequency as seen from the amplifier to a load side, wherein
the impedance adjustment unit comprises a distributed constant circuit and a lumped constant circuit,
the distributed constant circuit comprising a transmission line having a line length that resonates with a harmonic,
the lumped constant circuit comprising a resonance circuit that resonates with harmonics other than the harmonic in the distributed constant circuit and a fundamental wave.

2. The high-frequency amplifier according to claim 1, wherein the transmission line of the distributed constant circuit is an open stub that conducts impedance adjustment to obtain zero impedance for an even harmonic,
the resonant circuit of the lumped constant circuit is an inductive load that conducts the impedance adjustment to obtain high impedances for the fundamental wave and an odd harmonic, and
the impedance adjustment unit conducts the impedance adjustment for a class-F operation.

3. The high-frequency amplifier according to claim 2, wherein the resonance circuit of the inductive load consists of an inductor connected between a node on an output part of the distributed constant circuit and a node on an input part of a load and a capacitor connected between the node on the input part of the load and a grounding end.

4. The high-frequency amplifier according to claim 2 or 3, wherein the lumped constant circuit comprises a resonance circuit in place of an open stub for conducting the impedance adjustment to obtain zero impedance for a second harmonic.

5. The high-frequency amplifier according to claim 1, wherein the transmission line of the distributed constant circuit is an open stub that conducts the impedance adjustment to obtain zero impedance for an odd harmonic,
the lumped constant circuit is a circuit that consists of an inductor and a capacitor respectively for making a fundamental wave to be a predetermined inductive load and an even harmonic to be a capacity load for conducting the impedance adjustment to obtain a high impedance, and
the impedance adjustment unit conducts the impedance adjustment for an inverse class-F operation.

6. The high-frequency amplifier according to claim 5, wherein the capacitive load consists of a capacitor connected between a node on an output part of the distributed constant circuit and a grounding end and an inductor connected between the node and a node on an input part of a load.

7. The high-frequency amplifier according to claim 6, wherein the lumped constant circuit comprises a series circuit formed by an inductor and a capacitor, in place of an open stub for conducting the impedance adjustment to obtain zero impedance for a third harmonic.

8. The high-frequency amplifier according to claim 2, wherein two of the amplifiers that amplify high-frequency signals having phases opposite to each other form a push-pull circuit,
the two amplifiers are connected to the load via an output transformer, and
the inductive load consists of a leakage inductance of the output transformer and a capacitor on a secondary side in the impedance adjustment unit.

9. The high-frequency amplifier according to claim 2, wherein two of the amplifiers that amplify high-frequency signals having phases opposite to each other form a push-pull circuit,
the two amplifiers are connected to the load via an output transformer, and
the inductive load consists of an inductor connected in series on a primary side of the output transformer and a capacitor connected in parallel on a primary side or a secondary side of the output transformer in the impedance adjustment unit.

10. The high-frequency amplifier according to claim 2, wherein two of the amplifiers that amplify high-frequency signals having phases opposite to each other form a push-pull circuit,
the two amplifiers are connected to the load via an output transformer, and
the inductive load consists of an inductor connected in series on a secondary side of the output transformer and a capacitor connected in parallel on the secondary side of the output transformer in the impedance adjustment unit.

11. The high-frequency amplifier according to claim 5, wherein two of the amplifiers that amplify high-frequency signals having phases opposite to each other form a push-pull circuit,
the two amplifiers are connected to the load via an output transformer, and
the capacitive load consists of a capacitor that is connected in parallel on a primary or a secondary side of the output transformer and an inductor that is connected in series on the primary or the secondary side of the output transformer in the impedance adjustment unit.

12. The high-frequency amplifier according to any one of claims 2 to 7, wherein the open stub has its one end being an open end, and is a transmission line having a line length that is 1/4 of a wavelength of each harmonic.

13. The high-frequency amplifier according to claim 2, wherein the distributed constant circuit consists of a multi-layer substrate formed by a GND layer and a dielectric substrate layer,
the substrate layer being provided therein with an open stub that conducts the impedance adjustment to obtain zero impedance for a second harmonic.

14. The high-frequency amplifier according to claim 5, wherein the distributed constant circuit consists of a multi-layer substrate formed by a GND layer and a dielectric substrate layer,
the substrate layer being provided therein with an open stub that conducts the impedance adjustment to obtain zero impedance for a third harmonic.
